(19) **Europäisches Patentamt**
**European Patent Office**
**Office européen des brevets**

(11) **EP 2 442 076 A1**

(12) # EUROPÄISCHE PATENTANMELDUNG

(43) Veröffentlichungstag:
**18.04.2012 Patentblatt 2012/16**

(51) Int Cl.:
**G01D 4/10** *(2006.01)*     **G01R 21/133** *(2006.01)*

(21) Anmeldenummer: **10013714.0**

(22) Anmeldetag: **18.10.2010**

| | |
|---|---|
| (84) Benannte Vertragsstaaten:<br>**AL AT BE BG CH CY CZ DE DK EE ES FI FR GB GR HR HU IE IS IT LI LT LU LV MC MK MT NL NO PL PT RO RS SE SI SK SM TR**<br>Benannte Erstreckungsstaaten:<br>**BA ME** | (72) Erfinder: **Inan, Ali**<br>**91096 Möhrendorf (DE)** |
| (71) Anmelder: **ITF Fröschl GmbH**<br>**93194 Walderbach (DE)** | (74) Vertreter: **Graf Glück Habersack Kritzenberger**<br>**Postfach 10 08 26**<br>**93008 Regensburg (DE)** |

(54) **Elektrizitätszähler**

(57)     Elektrizitätszähler, der zumindest für mehrere lastvariable Tarife ausgebildet ist, die wahlweise einem Energiebezug und/oder einer Energielieferung zugeordnet werden können.

**EP 2 442 076 A1**

**Beschreibung**

Elektrizitätszähler zur Erfassung des Energiebezugs aus einem Versorgungsnetz sowie auch zur Erfassung der Energielieferung oder -einspeisung in ein Versorgungsnetz sind in unterschiedlichen Ausführungen bekannt, insbesondere auch als Elektrizitätszähler, die insbesondere im Zusammenwirken mit Zusatzgeräten eine zeitvariable oder lastvariable Tarifierung des Energiebezug bzw. der Energielieferung ermöglichen, d.h. mit zeitvariablen oder lastvariablen Tarifen ausgeführt sind.

Aufgabe der Erfindung ist es, einen Elektrlzitätszähler aufzuzeigen, der bei einer äußerst flexiblen Gestaltungsmöglichkeit der zeitvariablen und/oder lastvariablen Tarife sowohl eine Zählung des Energiebezugs als auch eine Zählung der Energielieferung ermöglicht

Zur Lösung dieser Aufgabe ist ein Elektrizitätszähler entsprechend dem Patentanspruch 1 ausgebildet.

Weiterbildungen, Vorteile und Anwendungsmöglichkeiten der Erfindung ergeben sich auch aus der nachfolgenden Beschreibung von Ausführungsbeispielen und aus den Figuren. Dabei sind alle beschriebenen und/oder bildlich dargestellten Merkmale für sich oder in beliebiger Kombination grundsätzlich Gegenstand der Erfindung, unabhängig von ihrer Zusammenfassung in den Ansprüchen oder deren Rückbeziehung. Auch wird der Inhalt der Ansprüche zu einem Bestandteil der Beschreibung gemacht.

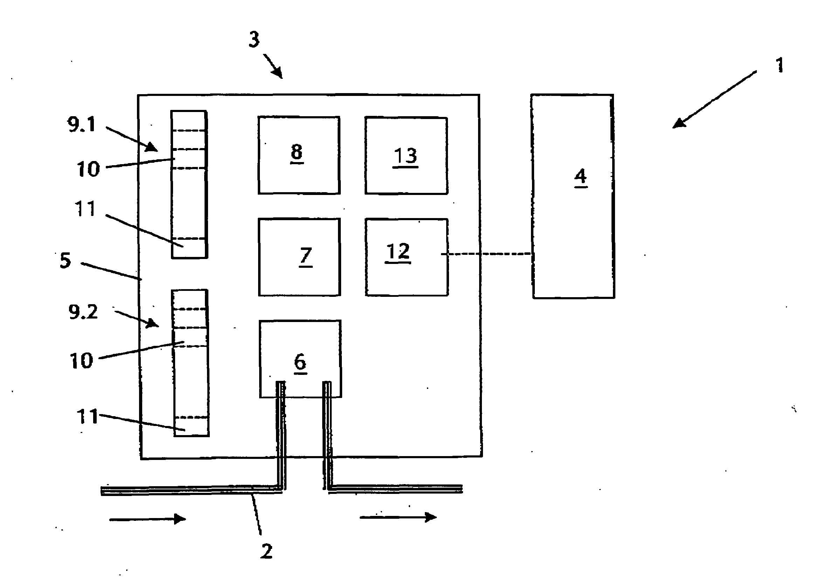

Die Erfindung wird im Folgenden anhand der Figur, die in einem Block- und/oder Funktionsdiagamm einen kommunikationsfähigen Elektrizitätszähler gemäß der Erfindung zeigt, näher erläutert.

Der in der Figur allgemein mit 1 bezeichnete Elektrizitätszähler zur Erfassung des Energiebezugs aus einem in dieser Figur allgemein mit 2 angedeuteten Versorgungsnetz, vorzugsweise aus einem elektrischen Vierleiter-Versorgungsnetz, und zur Erfassung der Energielieferung oder -einspeisung in das Versorgungsnetz 2, besteht bei der dargestellten Ausführungsform im Wesentlichen aus zwei Komponenten, nämlich aus dem eigentlichen, in der Figur mit 3 bezeichneten Zählermodul und aus einem Zusatzmodul 4.

Energiebezug bedeutet also die aus dem Versorgungsnetz 2 über den Elektrizitätszähler 1 an einen angeschlossenen Verbrauch gelieferte elektrische Energie. Energielieferung bedeutet die Einspeisung von elektrischer Energie über den Elektrizitätszähler 1 in das Versorgungsnetz 2.

Der Elektrizitätszähler 1 bzw. dessen Zählermodul 3 sind so ausgeführt, dass der Energiebezug, aber auch die Energielieferung jeweils unter Berücksichtigung mehrerer Tarife erfasst werden können, die wahlweise als zeitvariable oder als lastvariable Tarife ausgeführt und in beliebiger Weise, Anzahl und/oder Kombination eingestellt werden können.

Die zeitvariablen Tarife werden dabei von einem im Zusatzmodul 4 abgelegten Schaltprogramm mit entsprechenden Kommandos über eine Datenverbindung zwischen dem Zählermodul 3 und dem Zusatzmodul 4 gesteuert. Das Schaltprogramm ist beispielsweise ein fernladbares Programm, welches beispielsweise von einer nicht dargestellten Leitstelle in das Zusatzmodul 4 eingelesen wird und dem mit dem jeweiligen Kunden vertraglich vereinbarten zeitvariablen Tarif oder Tarifen für Energiebezug und/oder Energielieferung entspricht.

Die lastvariablen Tarife sind im Zählermodul 3 abgelegt, und zwar jeweils charakterisiert durch Maximal- oder Schwellwerte der Wirkleistung $P_{g/w}$, mit denen in der nachfolgend noch näher beschriebenen Weise die jeweils von dem Messmodul 3 erfasste momentane Wirkleistung P verglichen wird.

An dem nachfolgenden Beispiel wird die Funktionsweise des Elektrizitätszählers 1 bzw. des Messmoduls 3 näher erläutert, wobei davon ausgegangen wird, dass das Zählermodul 3 für Energiebezug und Energielieferung jeweils mit insgesamt neun unterschiedlichen Tarifen ausgestaltet werden kann, die dann zeitvariabel und lastvariabel beispielsweise wie folgt eingestellt werden:

- Sechs zeitvariable Tarife für Energiebezug und drei zeitvariable für Energiel ieferung
- Sechs zeitvariable Tarife für Energiebezug und drei lastvariable Tarife für Energielieferung
- Sechs lastvariable Tarife für Energiebezug und drei lastvariable Tarife für Energielieferung
- Sechs lastvariable Tarife für Energiebezug und drei zeitvariable Tarife für Energielieferung,

Die maximale momentane Leistung des Energiebezugs oder der Energielieferung ist:

$$P_{max} = 3 \times U \times I_{max}.$$

Wird Imax beispielsweise mit 60A angenommen, so ergibt sich

$$P_{max} = 3 \times 230 \times 60 = 41{,}40 \text{ kW oder abgerundet } 40\text{kW}$$

Diese maximale Wirkleistung von 40kW kann für die Festlegung der lastvariablen Tarife in eine Schrittfolge von jeweils 4 kW oder einem Vielfachen hiervon unterteilt werden, wobei die aufsteigenden Werte dieser Schrittfolge jeweils den für den lastvariablen Tarif zuständigen Wirkleistungsgrenzwert $P_{grw}$ darstellen.

Sind der Elektrizitätszähler 1 bzw. dessen Zählermodul 3 beispielsweise für sechs zeitvariable Tarif $T1_{bez}$ - $T6_{bez}$ für den Energiebezug und/oder für sechs zeitvariable Tarif $T1_{lief}$ - $T6_{lief}$ für die Energielieferung und mit drei lastvariablen Tarifen $T7_{bez}$ - $T9_{bez}$ für den Energiebezug und/oder mit drei lastvariablen Tarifen $T7_{lief}$ - $T9_{lief}$ für die Energielieferung eingestellt, so sind diesen lastvariablen Tarifen beispielsweise folgende Grenzwerte zugeordnet:

$T7_{bez}$ : 8 kW          $T7_{lief}$: 8 kW
$T8_{bez}$; 20 kW          $T8_{lief}$: 20 kW
$T9_{bez}$; 32 kW          $T9_{lief}$: 32 kW

Die Zuordnung der Wirkleistungsgrenzwerte $P_{grw}$ für die lastvariablen Tarife ist beispielsweise über das Zusatzmodul 4 in das Zählermodul 3 eingelesen und dort   abgelegt, sodass die jeweils gemessene momentane bzw. aktuelle Wirkleistung P im Zählermodul 3 mit den dort abgelegten Wirkleistungsgrenzwerten verglichen und der aktuelle Energiewert in ein dem betreffenden Tarif $T7_{bez}$ - $T9_{bez}$ oder $T7_{lief}$ - $T9_{lief}$ zugeordnetes Tarifregister eingezählt werden kann. Bei der vorgenannten Einstellung der Wirkleistungsgrenzwerte wird die aktuell gemessene Energie in Abhängigkeit von der aktuellen Wirkleistung P also wie folgt gezählt:

$P \leq 8$ kW          Energie wird in das Tarifregister $TR7_{bez}$ oder $TR7_{lief}$ gezählt
8 kW $\leq P \leq 20$ kW          Energie wird in das Tarifregister $TR8_{bez}$ oder $TR8_{lief}$ gezählt
20 kW $\leq P \leq 32$ kW          Energie wird in das Tarifregister $TR9_{bez}$ oder $TR9_{lief}$ gezählt,

Es versteht sich, dass die vorstehenden Ausführungen zur Anzahl und/oder Aufteilung der Tarife sowie zu den jeweiligen die lastvariablen Tarife definierenden Wirkleistungsgrenzwerten nur Beispielen darstellen, die Anzahl und/oder Aufteilung der Tarife auf zeitvariable und lastvariable Tarife, die die einzelnen lastvariablen Tarife definierenden Wirklelstungsgrenzwerte usw. auch abweichend von dem vorgenannten Beispiel gewählt sein können.

Für die vorgenannten Funktionen weist das Zählermodul 3 bei der dargestellten Ausführungsform in einem zugangsgeschützten, d.h. plombierten und/oder nur für berechtigte Personen zugänglichen Innenraum eines Zählergehäuses 5 u.a. folgende Komponenten auf:

- eine Messeinrichtung 6 zur Erfassung der physikalischen Werte Strom, Spannung und Phasenlage am Versorgungsnetz 2 und zur Bildung von entsprechenden vorzugsweise digitalen Messwerten, und zwar für jeden Leiter des Mehrleiterversorgungsnetzes,
- eine zentrale Steuer- und Datenverarbeitungseinheit 7 insbesondere zur Verarbeitung der von der Messeinheit 6 gelieferten Messwerte sowie auch für die Steuerung unterschiedlichster Funktionen des Zählermoduls 3,
- einen Daten- und Programmspeicher 8, in welchem u.a. die Wirkleistungsgrenzwerte $P_{grw}$ für die lastvariablen Tarife, beispielsweise für die Tarife $T7_{bez}$ - $T9_{bez}$ und $T7_{lief}$ - $T9_{lief}$ abgelegt sind,
- zwei Registeranordnungen 9.1 und 9.2, die mehrere Register 10, beispielsweise jeweils neun Einzelregister 10 aufweisen, von denen jeweils ein Register 10 nur einem Tarif zugeordnet ist, in das die diesem Tarif entsprechenden Energiebezüge oder -lieferungen eingezählt werden, und zwar die Energiebezüge in die Register 10 der Registeranordnung 9.1 und die Energielieferungen in die Register 10 der Registeranordnung 9.2;
- eine Schnittstelle 12 für einen beispielsweise bidirektionalen Datenverkehr mit dem Zusatzmodul 4, und zwar u.a. für die Steuerung der zeitvariablen Tarife, für die Einstellung der lastvariablen Tarife, aber auch bevorzugt für ein Fernauslesen der Zählerdaten und des Zählerstandes über eine nicht dargestellte Datenübertragungsstrecke, beispielsweise an dem Rechner eines Versorgungsunternehmens oder einer Leitstelle;
- eine Anzeige 13 zur Anzeige des Inhalts der Register 10 und/oder der Registeranordnungen 9.1 und 9.2.

Die von der Messeinheit 6 gelieferten Messwerte werden in der Datenverarbeitungs-und Steuereinheit 7 zu dem Energiebezug oder der Energielieferung entsprechenden Verbrauchswerten verarbeitet. Gleichzeitig wird in der Datenverarbeitungs- und Steuereinheit 7 die jeweils aktuelle Wirkleistung P mit den im Speicher 8 abgelegten Wirkleistungsgrenzwerten $P_{grw}$ verglichen und der aktuelle Energiewert des Energiebezugs oder der Energielieferung in dem der aktuellen Wirkleistung P entsprechenden und als Tarifregister TR ausgewählten Register 10 eingelesen.

Vor Inbetriebnahme des Elektrizitätszählers werden die den lastvariablen Tarifen T7ba - $T9_{bez}$ und $T7_{lief}$ - $T9_{lief}$

zugeordneten Wirkleistungsgrenzwerte $P_{grw}$ in den Speicher 8 eingelesen und auch festgelegt, welche Register 10 den einzelnen lastvariablen Tarifen zugeordnet sind.

Da der Elektrizitätszähler 1 auch für solche Anwendungen geeignet ist, bei denen zeitweise ein Energiebezug aus dem Versorgungsnetz 2, zeitweise aber auch eine Energielieferung in das Versorgungsnetz 2 erfolgt, sind nicht nur die Messeinrichtung 6 und die Datenverarbeitungs- und Steuereinrichtung 7 so ausgeführt, dass der Energiebezug und die Energielieferung eindeutig in den von der Messeinheit 6 gelieferten Messwerten und/oder durch entsprechende Verarbeitung in der Datenverarbeitungs- und Steuereinheit 7 unterschieden werden, sondern es sind bei dargestellten Ausführungsform zwei Registeranordnungen 9.1 und 9.2 vorgesehen, und zwar die Registeranordnung 9.1 für den Energiebezug und die Registeranordnung 9.2 für die Energielieferung.

Bevorzugt weist das Zählermodul 3 zusätzlich zu den den einzelnen Tarifen zuzuordnenden Registern 10 in jeder Registeranordnung 9.1 und 9.2 wenigstens ein zusätzliches Register 11 auf, in welchem unabhängig von den Tarifen der Gesamtenergiebezug bzw. die Gesamtenergielieferung eingelesen wird, sodass durch Vergleich der Summe der Energiebezüge bzw. der Energielieferungen, die in die verschiedenen Register 10 eingelesen wurden, mit dem im Register 11 eingelesenen Gesamtenergiebezug bzw. mit der im Register 11 eingelesenen Gesamtenergielieferung die ordnungsgemäße Zählung durch den Elektrizitätszähler bzw. das Zählermodul 3 überwacht werden kann, die (ordnungsgemäße Zählung) dann gegeben ist, wenn die Summe der Inhalte der Register 10 gleich dem Inhalt des zugehörigen Registers 11 ist.

Die zeitvariablen Tarife für Energiebezug und Energielieferung werden dadurch berücksichtigt, dass durch Befehle, die von dem Zusatzmodul 4 abgelegten Schaltprogramm veranlasst werden und über die Schnittstelle 12 an die Datenverarbeitungs- und Steuereinheit 7 gelangen, diese Einheit die dem jeweiligen zeitvariablen Tarif entsprechenden Energiebezug bzw. die dem jeweiligen zeitvariablen Tarife für Energielieferung entsprechenden Tarif an das diesem zeitvariablen Tarif zugeordnete Register 10 der Registeranordnung 9.1 bzw. 9.2 zur Zählung weiterleitet.

Bevorzugt ist der Elektrizitätszähler 1 so ausgebildet, dass er vor seiner Inbetriebnahme völlig frei in Bezug auf die Wahl der Anzahl und/oder Art und/oder Verteilung der Tarife auf zeitvariable und lastvariable Tarife, auf die Einstellung der diese Tarife kennzeichnenden Größen, insbesondere Zeiten für die Steuerung der Zeitvariablen Tarife und der Wirkleistungsgrenzwerte $P_{grw}$ für die lastvariablen Tarife ist,

Weiterhin ist der Elektrizitätszähler 1 so ausgeführt, dass er nicht nur wahlweise für einen Energiebezug aus dem Versorgungsnetz 2 und für eine Energielieferung an dieses Versorgungsnetz ausgebildet ist, sondern sowohl der Energiebezug, als auch die Energielieferung mit ein und demselben Elektrizitätszähler erfasst werden können. Die Anzahl der Tarife für den Energiebezug und die Energielieferung ist durch entsprechende Wahl der Anzahl der Register 10 praktisch unbegrenzt.

Bevorzugt ist der Elektrizitätszähler 1 auch für ein Fernauslesen der in den Registern der Registeranordnungen 9.1 und 9.2 abgelegten Zählwerte (Energiebezug und/oder Energielieferung) ausgebildet.

Die Erfindung wurde voranstehend an Ausführungsbeispielen beschrieben. Es versteht sich, dass zahlreiche Änderungen sowie Abwandlungen möglich sind, ohne dass dadurch der der Erfindung zugrundeliegende Erfindungsgedanke verlassen wird.

Insbesondere ist es möglich, dass die Komponenten des Zählermoduls 3, insbesondere auch solche für die Verarbeitung der von der Messeinheit 6 gelieferten Messwerte, der Speicherung der Energiewerte usw. zumindest teilweise Bestandteil eines Mikroprozessors oder eines anderen modularen Schaltkreises sind und/oder vorbeschriebene Elemente des Zählermoduls 3 und/oder deren Funktionen softwaremäßig realisiert sind.

**Bezugszeichenliste**

| | |
|---|---|
| 1 | Elektrizitätszähler |
| 2 | elektrisches Versorgungsnetz |
| 3 | Zählermodul |
| 4 | Zusatzmodul |
| 5 | Gehäuse |
| 6 | Messeinheit |
| 7 | Datenverarbeitungs- und Steuereinheit |
| 8 | Speicher |
| 9.1, 9.2 | Registeranordnung |
| 10, 11 | Register |
| 12 | Schnittstelle |

13        Anzeige

**Patentansprüche**

1. Elektrizitätszähler, **dadurch gekennzeichnet, dass** er oder ein Zählermodul (3) des Elektrizitätszähler (1) zumindest für mehrere lastvariable Tarife ausgebildet ist, die wahlweise einem Energiebezug und/oder einer Energielieferung zugeordnet werden können.

2. Zähler nach Anspruch 1, **dadurch gekennzeichnet, dass** der Elektrizitätszähler (1) > oder ein Zählermodul (3) mehrere Register (10, 11) aufweist, die wahlweise zeitvariablen oder lastvariablen Tarifen für den Energiebezug oder die Energielieferung als Tarifregister (TR) zugeordnet werden können.

3. Elektrizitätszähler nach Anspruch 2, **dadurch gekennzeichnet, dass** die Register (10, 11) einer Registeranordnung (9.1) für die Zählung des Energiebezugs und die Register (10) eine weiteren Registeranordnung (9.2) für die Zählung der Energielieferung vorgesehen sind.

4. Elektrizitätszähler nach Anspruch 2 oder 3, **dadurch gekennzeichnet, dass** die Register (10, 11) einer gemeinsamen Registeranordnung für die Zählung des Energiebezugs und für die Zählung der Energielieferung vorgesehen sind..

5. Elektrizitätszähler nach einem der vorhergehenden Ansprüche, **dadurch gekennzeichnet, dass** die Register (10, 11) der wenigstens einen Registeranordnung (9.1, 9.2) frei wählbar zeitvariablen und/oder lastvariablen Tarifen für Energiebezug und/oder Energielieferung zugeordnet werden können,

6. Elektrizitätszähler nach einem der vorhergehenden Ansprüche, **dadurch gekennzeichnet, dass** die von einer Messeinheit des Elektrizitätszählers (1) oder des Zählermoduls (3) gelieferten und dem Energiebezug oder der Energielieferung entsprechenden Messwerte mit Zählermodul (3) mit dort abgelegten, den lastvariablen Tarifen entsprechenden Wirkleistungsgrenzwerten ($P_{grw}$) verglichen und der Energiebezug oder die Energielieferung in das dem jeweiligen lastvariablen Tarif zugeordnete Register eingelesen werden.

7. Elektrizitätszähler nach einem der vorhergehenden Ansprüche, **dadurch gekennzeichnet, dass** der Zähler auch für zeitvariable Tarife für Energiebezug und Energielieferung ausgebildet ist.

8. Elektrizitätszähler, **gekennzeichnet durch** ein Zusatzmodul, in welchem ein Schaltprogramm, vorzugsweise ein fernladbares Schaltprogramm zur Steuerung der zeitvariablen Tarife abgelegt ist.

9. Elektrizitätszähler nach einem der vorhergehenden Ansprüche, **dadurch gekennzeichnet, dass** die die lastvariablen Tarife kennzeichnenden Wirkleistungsgrenzwerte ($P_{grw}$) variabel und/oder in den Elektrizitätszähler (1) oder in das Zählermodul (3) einlesbar sind.

10. Elektrizitätszähler nach einem der vorhergehenden Ansprüche, **dadurch gekennzeichnet, dass** die die lastvariablen Tarife kennzeichnenden Wirkleistungsgrenzwerte ($P_{grw}$) als Folge mit ansteigendem Leistungswert abgelegt sind, beispielsweise als Folge oder Reihe mit konstantem oder sich ändernden Intervallschritten.

**Europäisches Patentamt**
**European Patent Office**
**Office européen des brevets**

## EUROPÄISCHER RECHERCHENBERICHT

**Nummer der Anmeldung**

EP 10 01 3714

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | WO 01/01156 A1 (GEN ELECTRIC [US]; BALCH RICHARD A [US]; ELMORE DAVID D [US]; SCHMIDT) 4. Januar 2001 (2001-01-04)<br>* Seite 3, Zeile 23 - Seite 10, Absatz 2 *<br>* Seite 14, Zeile 1 - Zeile 3 *<br>* Seite 27, Zeile 23 - Seite 29, Zeile 9 *<br>* Seite 32, Zeile 8 - Zeile 10 *<br>* Seite 33, Zeile 9 - Zeile 20 *<br>* Abbildungen 1-3 *<br>----- | 1-10 | INV.<br>G01D4/10<br>G01R21/133 |
| X | WULLSCHLEGER P: "TARIFGERATE TARIGYR 400 KONZEPT - LOESUNGEN - AUFBAU",<br>LANDIS UND GYR MITTEILUNGEN, LANDIS UND GYR A.G. ZUG, CH,<br>Bd. 32, Nr. 1, 1. Januar 1985 (1985-01-01)<br>, Seiten 4-08, XP000655052,<br>* Absatz [0003] - Absatz [0003] *<br>* Absatz [0004] - Absatz [0004] *<br>----- | 1,2,5, 8-10 | |
| A | WO 03/014748 A1 (SIEMENS METERING LTD [GB]; LOE ROBERT [GB]) 20. Februar 2003 (2003-02-20)<br>* Seite 3, Zeile 10 - Zeile 16 *<br>* Seite 7, Zeile 19 - Zeile 27 *<br>* Seite 9, Zeile 12 - Zeile 18 *<br>* Seite 10, Zeile 18 - Seite 11, Zeile 12 *<br>* Abbildungen 1,4 *<br>----- | 1-10 | RECHERCHIERTE SACHGEBIETE (IPC)<br><br>G01D<br>G01R |

Der vorliegende Recherchenbericht wurde für alle Patentansprüche erstellt

| Recherchenort | Abschlußdatum der Recherche | Prüfer |
|---|---|---|
| Den Haag | 23. Mai 2011 | Keita, Mamadou |

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 10 01 3714

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

23-05-2011

| Im Recherchenbericht angeführtes Patentdokument | Datum der Veröffentlichung | Mitglied(er) der Patentfamilie | Datum der Veröffentlichung |
|---|---|---|---|
| WO 0101156      A1 | 04-01-2001 | AU     6060700  A<br>BR     0006867  A<br>CA     2340886  A1<br>EP     1108218  A1 | 31-01-2001<br>05-06-2001<br>04-01-2001<br>20-06-2001 |
| WO 03014748     A1 | 20-02-2003 | GB     2379993  A | 26-03-2003 |

EPO FORM P0461

Für nähere Einzelheiten zu diesem Anhang : siehe Amtsblatt des Europäischen Patentamts, Nr.12/82